# FASCICULE DE BREVET EUROPEEN

(11) **EP 2 297 384 B1**
(45) Date de publication et mention de la délivrance du brevet: **15.02.2012**
(21) Numéro de dépôt: 09742015.2
(22) Date de dépôt: 29.04.2009
(51) Int. Cl.: C30B 29/60, C30B 7/00, B82B 1/00, C09K 11/08

(54) **PROCÉDÉ DE PRÉPARATION DE NANOCRISTAUX LUMINESCENTS**
VERFAHREN ZUR HERSTELLUNG VON LUMINESZIERENDEN NANOKRISTALLEN
METHOD OF PREPARING LUMINESCENT NANOCRYSTALS

(30) Priorité: 05.05.2008 FR 0852977
(43) Date de publication de la demande: 23.03.2011
(73) Titulaire: Commissariat à l'Énergie Atomique et aux Énergies Alternatives, 75015 Paris (FR)
(72) Inventeur: REISS, Peter, F-38120 Saint Egrève (FR); LI, Liang, 87544 Los Alamos New Mexico (US)
(74) Mandataire: Ilgart, Jean-Christophe
(86) Numéro de dépôt international: PCT/EP2009/055231
(87) Numéro de publication internationale: WO 2009/135797

(56) Documents cités:
- WO-A1-2006/134599
- WO-A2-2005/110916
- US-A1- 2007 034 833
- HAUBOLD ET AL: "Strongly luminescent InP/ZnS core-shell nanoparticles" CHEMSHYSCHEM, A EUROPEAN JOURNAL OF CHEMICAL PHYSICS & PHYSICALCHEMISTRY, vol. 2, no. 5, 2001, pages 331-334, XP003021606 WILEY VCH, WEINHEIM, DE ISSN: 1439-4235 cité dans la demande
- MICIC ET AL: "Core-shell quantum dots of lattice matched ZnCdSe2 shells on InP cores: experiment and theory" J. PHYS.CHEM B, vol. 104, 2000, pages 12149-12156, XP002504286 cité dans la demande
- XIE ET AL: "Colloidal InP nanocrystals as efficient emitters covering blue to near infrared" J.AM.CHEM.SOC, vol. 129, 23 novembre 2007 (2007-11-23), pages 1542-15433, XP008098788 cité dans la demande

## Description

### DOMAINE TECHNIQUE

La présente invention concerne un procédé de fabrication de nouveaux matériaux luminescents à base de nanocristaux « coeur/coquille » à base de semi-conducteurs qui présentent une grande pureté de couleur et un rendement quantique de fluorescence amélioré par rapport aux systèmes existant actuellement, tout en couvrant l'essentiel du spectre visible.

La présente invention concerne également les matériaux luminescents ainsi obtenus tout comme leurs différentes utilisations. En effet, le champ d'application de ces nanocristaux comprend par exemple les diodes électroluminescentes, les cellules photovoltaïques et le marquage fluorescent de molécules chimiques ou biologiques.

### ÉTAT DE LA TECHNIQUE ANTÉRIEURE

Les cristaux de semi-conducteurs sont des matériaux luminescents connus depuis plusieurs décennies. Dans les années 1980-1990, il a été montré que leur spectre d'émission dépend de la taille du cristal lorsque celle-ci devient suffisamment petite. Pour des cristaux dont la taille se situe approximativement dans la gamme allant de 1 à 10 nm appelés « nanocristaux » ou « boîtes quantiques », cette dépendance est extrêmement prononcée. De fait, la palette entière des couleurs du visible et des proches infrarouge et ultraviolet peut être obtenue avec des nanocristaux semi-conducteurs par le choix approprié de leur taille et de leur composition. Pour couvrir le spectre visible, ce qui est très important dans le domaine de l'éclairage et de l'affichage (écrans plats), les matériaux les plus étudiés sont les chalcogénures de cadmium (CdS, CdSe, CdTe). Cependant, la directive européenne RoHS (« Restriction of Hazardous Substances ») vise l'élimination des substances suivantes dans les équipements électriques et électroniques (EEE), commercialisés en Europe à partir du 1er juillet 2006 : Plomb, Mercure, Cadmium, Chrome hexavalent, Polybromobiphényles (PBB), Polybromodiphenyléthers (PBDE). Il est donc indispensable de trouver des matériaux alternatifs contenant avantageusement aucune de ces substances pour la fabrication des nanocristaux, tout en gardant les propriétés optiques recherchées.

D'une manière générale, la qualité optique d'un matériau luminescent composé de nanocristaux dépend de plusieurs paramètres, dont les plus importants sont :
- la taille des nanocristaux, qui règle la longueur d'onde d'émission ;
- la distribution de taille des nanocristaux, qui contrôle la largeur de raie d'émission ;
- la passivation de surface des nanocristaux, responsable du rendement quantique de fluorescence et de la stabilité dans le temps.

Le phosphure d'indium (InP) est un des matériaux les plus intéressants pour substituer les nanocristaux à base de cadmium. Grâce à sa largeur de bande interdite de 1,35 eV, il est possible de varier la longueur d'onde d'émission des nanocristaux d'InP dans le spectre visible et dans le proche infrarouge en changeant leur taille.

Il existe plusieurs méthodes de préparation des nanocristaux d'InP parmi lesquelles, à ce jour, la méthode d'injection rapide des précurseurs dans un solvant organique à haute température donne accès à la dispersion en taille la plus étroite. Une faible dispersion en taille des nanocristaux mène à un spectre d'émission étroit (une couleur d'émission pure) ; ceci est bien sûr avantageux pour les applications technologiques. Deux principales voies de synthèse existent.

La première voie, la voie de synthèse organométallique dite « classique » consiste à faire réagir à température élevée (270-300°C) un précurseur d'indium (e.g. le chlorure d'indium ou l'oxalate de chloroindium) avec le précurseur de phosphore (la tris (triméthylsilyl)phosphine, P(TMS)₃, P (Si (CH₃)₃)₃) dans de l'oxyde de trioctylphosphine (TOPO) qui sert de milieu réactif [1], [2] et [3]. Le TOPO est dénommé un « solvant coordinant » pour souligner sa capacité de se lier à la surface des nanocristaux et de les stabiliser ainsi sous forme de colloïdes. Les principaux désavantages de cette méthode sont la dispersion en taille élevée des nanocristaux préparés et la longue durée de la réaction (3-7 jours).

La seconde voie de synthèse est une modification de la voie de synthèse « classique » publiée en 2002. Dans cette dernière, le milieu réactif, au lieu de TOPO, est un simple alcène, le 1-octadécène, classifié « solvant non-coordinant » [4]. Par ailleurs, des acides gras, tels que l'acide laurique, myristique ou palmitique ont été utilisés en tant que ligands stabilisants. La réaction démarre par l'injection rapide du précurseur de phosphore (P(TMS)₃) dans le solvant porté à 300°C qui contient le précurseur d'indium (acétate d'indium) et le stabilisant. Les auteurs rapportent une amélioration de la dispersion de taille qui se situe alors autour de 10%. De plus, la durée de la réaction est réduite à 3-4 heures.

Toutefois, les méthodes de préparation décrites ci-dessus ne résolvent pas le problème du rendement quantique de fluorescence qui demeure faible (typiquement inférieur à 1%). Une méthode largement utilisée pour augmenter le rendement quantique des nanocristaux de matériaux variés (e.g. CdSe, CdS, etc.) consiste à passiver leur surface en faisant croître autour de ce « coeur » une coquille d'un semi-conducteur à largeur de bande interdite supérieure. Ce système est dénommé « coeur/coquille » dans la littérature scientifique. Les méthodes utilisées pour le dépôt de la coquille sont essentiellement les mêmes que celles employées pour la préparation du coeur.

Pour améliorer les propriétés optiques des nanocristaux d'InP, différents matériaux de coquille ont été proposés. Micic *et coll*. décrivent la synthèse d'un composé ternaire, CdZnSe₂, à la surface d'InP, dans le but de minimiser le désaccord de maille entre le matériau du coeur et de la coquille [5]. Un grand désaccord de maille peut entraîner des défauts cristallins dans la coquille ou à l'interface coeur/coquille et diminuer ainsi l'efficacité de fluorescence. Néanmoins le rendement quantique atteint avec ce système coeur/coquille (10%) reste largement inférieur aux valeurs obtenues avec les nanocristaux à base de cadmium (50-85%).

Haubold *et coll.* ont recouvert l'InP par le ZnS et obtenu un rendement quantique entre 15% après 3 jours et 23% après 3 semaines [6]. Le procédé utilisé pour la synthèse de ces nanocristaux coeur/coquille impliqué :
a₁) la synthèse de cristaux coeur InP selon la 1^{ère} voie de synthèse décrite ci-dessus ;
a₂) la purification des cristaux d'InP par précipitation et lavage avec du méthanol ;
a₃) la croissance de la coquille de ZnS. Pour cette étape, les nanocristaux d'InP sont dispersés dans de la trioctylphosphine (TOP) à 200°C, et un mélange de diéthylzinc et de sulfure de bis(triméthylsilyl) est injecté. La température est ensuite augmentée brièvement à 260°C avant de la faire décroître à 100°C pendant 1h. Par la suite, le mélange réactionnel est gardé sous atmosphère inerte (azote) pendant plusieurs jours voire semaines ;
a₄) la purification par précipitation et lavage des nanocristaux avec du méthanol ;
a₅) la séparation de l'échantillon en fractions de taille par précipitation sélective.

Les problèmes liés à cette méthode viennent du fait de l'utilisation des précurseurs pyrophoriques pour la croissance de la coquille (diéthylzinc et sulfure de bis (triméthylsilyl)), l'évolution des propriétés optiques pendant très longtemps (des semaines), et finalement du rendement quantique relativement faible par rapport aux systèmes coeur/coquille à base de semi-conducteurs II-VI. Les auteurs concluent que la couverture par la coquille de ZnS de nanocristaux d'InP n'est pas complète ce qui limiterait le rendement quantique de fluorescence.

Plus récemment, Peng *et* coll. ont proposé un nouveau protocole de synthèse des nanocristaux coeur/coquille InP/ZnS [7]. Dans ce cas, la synthèse des cristaux coeur est similaire à la 2^{nde} voie de synthèse telle que précédemment décrite, mais l'ajout d'une amine (1-octylamine), injectée en même temps que le précurseur de phosphore permet d'effectuer la réaction à 180-190°C au lieu de 270-300°C. La croissance de la coquille se fait ensuite de la manière suivants :
b₁) à 150°C une certaine quantité de distéarate de zinc (précurseur de zinc) est injectée dans le ballon contenant les nanocristaux d'InP. Dix minutes plus tard, la même quantité de soufre élémentaire dissout dans de l'octadécène (précurseur de soufre) est ajoutée ;
b₂) la température est augmentée à 220°C pendant 30 minutes pour faire croître la coquille en ZnS ;
b₃) la température est baissée à nouveau à 150°C pour répéter l'ajout du précurseur de zinc, suivi par le précurseur de soufre en utilisant une quantité plus grande et la même séquence qu'auparavant ;
b₄) la température est augmentée à 220°C pendant 30 minutes ;
b₅) les nanocristaux sont purifiés par ajout d'hexane et extraction avec du méthanol.

Bien que cette méthode permette de s'affranchir des précurseurs pyrophoriques pour la croissance de la coquille et de la purification intermédiaire entre la synthèse des cristaux coeur et la croissance de la coquille, le procédé reste compliqué à mettre en oeuvre. Les difficultés pour son adaptation à une échelle industrielle sont notamment liées à l'injection rapide du précurseur pyrophorique de phosphore pendant la synthèse des cristaux d'InP et au contrôle de la température pendant les multiples injections des précurseurs de ZnS. Le rendement quantique de fluorescence des nanocristaux obtenus avec cette méthode atteint 40%. Toujours inférieure par rapport aux nanocristaux à base des chalcogénures de cadmium, cette valeur est la meilleure publiée pour les nanocristaux à base d'InP. Dans le procédé divulgué dans le document US-A-2007/0034833 on obtient des rendements supérieurs à 40%. Pour des nanostructures avec un noyau de InP.

En résumé, les méthodes de fabrication des nanocristaux à base d'InP reportées à ce jour ne permettent pas d'atteindre des rendements quantiques de fluorescence supérieurs à 50%, ce qui limite leur application technologique. Les procédés décrits pour la synthèse des nanocristaux d'InP ayant une faible dispersion en taille impliquent l'injection rapide d'un précurseur pyrophorique dans un milieu réactionnel à température élevée, difficilement réalisable à plus grande échelle.

Finalement, la synthèse des nanocristaux coeur/coquille InP/ZnS exige un procédé en deux étapes, la synthèse des cristaux coeur InP, puis la croissance de la coquille ZnS, pendant laquelle des précurseurs doivent à nouveau être injectés dans le milieu réactionnel tout en contrôlant précisément la température.

### EXPOSÉ DE L'INVENTION

La présente invention permet de résoudre les problèmes techniques et désavantages précédemment listés.

En effet, la présente invention propose un nouveau procédé pour la synthèse des nanocristaux coeur/coquille InP/ZnS ayant un rendement quantique de fluorescence plus élevé que les valeurs rapportées à ce jour et notamment supérieur à 50% à température ambiante et ayant également une grande stabilité contre la photo-oxydation.

Le procédé de la présente invention est beaucoup plus simple que toutes les méthodes décrites dans l'état de l'art puisque la synthèse des nanocristaux coeur/coquille InP/ZnS s'effectue en une seule étape. Le procédé de l'invention ne nécessite aucune étape de purification intermédiaire. De plus, aucune étape de tri en taille (e.g. par précipitation sélective) est requise du fait de la faible dispersion en taille des échantillons obtenus directement après la synthèse.

Le procédé est, en outre, caractérisé par l'absence d'injection des précurseurs et notamment d'injection rapide du précurseur pyrophorique du phosphore dans le milieu réactionnel à température élevée. Le (ou les) précurseur(s) peut(vent) simplement être ajouté(s) à température ambiante au mélange réactionnel. De plus, aucun ajout d'un quelconque précurseur n'est nécessaire après le début de la réaction et la montée en température.

Enfin, le procédé de la présente invention est remarquable car non seulement il permet la préparation de nanocristaux coeur/coquille InP/ZnS, mais aussi il est généralisable à la préparation de nanocristaux coeur/coquille avec un coeur comprenant un semi-conducteur de formule AB et une coquille comprenant au moins un semi-conducteur de formule CD avec A représentant un métal ou métalloïde à l'état d'oxydation +III, B représentant un élément à l'état d'oxydation -III, C représentant un métal ou métalloïde à l'état d'oxydation +II et D représentant un élément à l'état d'oxydation -II.

La présente invention concerne un procédé de préparation d'un nanocristal présentant (i) un coeur comprenant un semi-conducteur comprenant A représentant un métal ou métalloïde à l'état d'oxydation +III et B représentant un élément à l'état d'oxydation -III, revêtu par (ii) une coquille dont la partie externe comprend un semi-conducteur de formule ZnS₁₋ₓEₓ, avec E représentant un élément à l'état d'oxydation -II et x étant un nombre décimal tel que 0 ≤ x < 1, ledit procédé comprenant une étape consistant à porter un mélange d'au moins un précurseur de A, d'au moins un précurseur de B, d'au moins un précurseur de zinc, d'au moins un précurseur de soufre et éventuellement d'au moins un précurseur de E, d'une température T₁ à une température T₂ supérieure à T₁ de façon croissante et de manière à former, tout d'abord, ledit coeur puis ladite coquille.

Plus particulièrement, le procédé de la présente invention comprend les étapes suivantes :
a) préparer un mélange d'au moins un précurseur de A, d'au moins un précurseur de B, d'au moins un précurseur de zinc, d'au moins un précurseur de soufre et éventuellement d'au moins un précurseur de E, à ladite température T₁,
b) porter le mélange obtenu à l'étape (a) à ladite température T₂,
c) purifier les nanocristaux présentant un coeur comprenant un semi-conducteur de formule AB entouré d'une coquille dont la couche externe comprend un semi-conducteur de formule ZnS₁₋ₓEₓ, obtenus à l'étape (b).

Le coeur du nanocristal préparé selon le procédé de l'invention comprend un semi-conducteur comprenant A représentant un métal ou métalloïde à l'état d'oxydation +III et B représentant un élément à l'état d'oxydation -III, ce type de semi-conducteur étant appelé III-V.

A, le métal ou métalloïde à l'état d'oxydation +III, formant avec B le semi-conducteur compris dans le coeur du nanocristal préparé selon l'invention est choisi parmi le gallium (Ga), l'indium (In), l'aluminium (A1) et leurs mélanges.

B, élément à l'état d'oxydation -III, formant avec A le semi-conducteur compris dans le coeur du nanocristal préparé selon l'invention est choisi parmi l'antimoine (Sb), l'arsenic (As), le phosphore (P), l'azote (N) et leurs mélanges.

Des exemples de semi-conducteurs de formule AB compris dans le coeur du nanocristal préparé selon le procédé de l'invention sont GaAs, GaSb, GaN, GaP, InAs, InSb, InN, InP, AlAs, AlSb, AlN, AlP, InGaAs, InGaSb, InGaN, InGaP, InAlAs, InAlSb, InAlN, InAlP, GaAlAs, GaAlSb, GaAlN, GaAlP et leurs mélanges. En particulier, le coeur du nanocristal préparé selon le procédé de l'invention comprend un semi-conducteur de formule AB choisi parmi InP, InAs, InGaP et leurs mélanges et, plus particulièrement, ledit semi-conducteur est l'InP.

Avantageusement, le coeur du nanocristal préparé selon le procédé de l'invention est constitué exclusivement d'un semi-conducteur tel que précédemment défini.

Le nanocristal préparé selon le procédé de la présente invention présente une coquille dont la partie externe comprend un semi-conducteur de formule ZnS₁₋ₓEₓ, avec E représentant un élément à l'état d'oxydation -II et x étant un nombre décimal tel que 0 ≤ x < 1.

E est un élément à l'état d'oxydation -II notamment choisi parmi l'oxygène (0), le sélénium (Se), le tellure (Te) et leurs mélanges.

La coquille du nanocristal préparé selon le procédé de l'invention peut être constituée d'une seule couche ou de plusieurs couches (i.e. être une coquille multicouche). Dans le cas où la coquille n'est constituée que d'une couche, la partie externe de la coquille correspond à ladite couche.

Dans le cas où la coquille est constituée de plusieurs couches, la partie externe de la coquille correspond à la couche externe de la coquille. Par « couche externe », on entend dans le cadre de la présente invention la couche de la coquille la plus éloignée du coeur du nanocristal et en contact direct avec le milieu ou l'environnement dans lequel le nanocristal se trouve. Une coquille multicouche peut comprendre de 2 à 10, notammment de 2 à 5 couches de semi-conducteurs différents. Ainsi, différentes variantes sont envisageables pour la coquille du nanocristal préparé par le procédé de l'invention.

Dans une première variante, x dans la formule ZnS₁₋ₓEₓ est égal à 0 et la coquille n'est formée que d'une couche qui est donc une couche de ZnS.

Dans une seconde variante, x dans la formule ZnS₁₋ₓEₓ est tel que 0 < x < 1 et la coquille n'est formée que d'une couche.

Dans une troisième variante, x dans la formule ZnS₁₋ₓEₓ est égal à 0 et la coquille comprend au moins deux couches différentes parmi lesquelles la couche externe est une couche de ZnS.

Dans une quatrième variante, x dans la formule ZnS₁₋ₓEₓ est tel que 0 < x < 1 et la coquille comprend au moins deux couches différentes.

De plus, la (ou les) couche(s) de la coquille du nanocristal préparé selon le procédé de l'invention peut(vent) présenter une composition chimique uniforme ou, à l'intérieur, d'une même couche, une composition chimique qui diffère et notamment une composition chimique sous forme de gradient. Dans ce cas de figure, la partie externe de la coquille sera constituée par la zone externe d'une coquille à une couche et par la zone externe de la couche externe d'une coquille multicouche.

Lorsque la coquille est multicouche, la (ou les) couche(s) comprise(s) entre le coeur du nanocristal et la couche externe de formule ZnS₁₋ₓEₓ telle que précédemment définie peuvent comprendre un semi-conducteur de formule AB telle que précédemment définie et/ou un semi-conducteur de formule CD avec C représentant un métal ou métalloïde à l'état d'oxydation +II et D représentant un élément à l'état d'oxydation -II. Un semi-conducteur de formule CD est également appelé II-VI.

Le métal ou métalloïde C à l'état d'oxydation +II, est notamment choisi parmi le magnésium (Mg), le calcium (Ca), le strontium (Sr), le baryum (Ba), le zinc (Zn), le cadmium (Cd), le mercure (Hg), l'étain (Sn), le plomb (Pb) et leurs mélanges. L'élément D à l'état d'oxydation -II est notamment choisi parmi l'oxygène (O), le soufre (S), le sélénium (Se), le tellure (Te) et leurs mélanges. Des exemples de semi-conducteurs pouvant être présents dans les couches comprises entre le coeur du nanocristal et la couche externe de la coquille sont, par exemple, MgS, MgSe, MgTe, CaS, CaSe, CaTe, SrS, SrSe, SrTe, BaS, BaSe, BaTe, ZnO, ZnS, ZnSe, ZnTe, CdS, CdSe, CdTe, HgS, HgSe, HgTe, SnS, SnSe, SnTe, PbS, PbSe, PbTe et leurs mélanges. Plus particulièrement, des exemples de semi-conducteurs pouvant être présents dans les couches comprises entre le coeur du nanocristal et la couche externe de la coquille sont choisis dans le groupe constitué par MgS, MgSe, MgTe, CaS, CaSe, CaTe, SrS, SrSe, SrTe, BaS, BaSe, BaTe, ZnO, ZnS, ZnSe, ZnTe, SnS, SnSe, SnTe et leurs mélanges.

Il est donc clair que, dans le cas d'une coquille multicouche, le mélange réactionnel mis en oeuvre dans le cadre de la présente invention et notamment à l'étape (a) contient en outre les précurseurs des éléments constituant les couches autres que la couche externe de la coquille.

Le nanocristal préparé par le procédé de la présente invention a un diamètre inférieur à 15 nm, notamment inférieur à 12 nm et en particulier inférieur à 10 nm.

Le coeur du nanocristal préparé par le procédé selon l'invention a un diamètre compris entre 1 et 10 nm, notamment entre 1,5 et 8 nm et en particulier entre 2 et 6 nm.

La coquille du nanocristal préparé par le procédé selon l'invention a une épaisseur comprise entre 0,3 et 6 nm, notamment entre 0,5 et 4 nm et en particulier entre 1 et 2 nm.

Dans le cadre de la présente invention, le précurseur de A mis en oeuvre est choisi dans le groupe constitué par un précurseur d'indium, un précurseur de gallium, un précurseur d'aluminium et leurs mélanges. Tous les précurseurs d'indium, d'aluminium et de gallium connus de l'homme du métier et notamment les précurseurs se présentant sous forme liquide ou solide sont utilisables dans la présente invention.

Avantageusement, le précurseur de A est choisi parmi les sels de A, les halogénures de A, les oxydes de A et les composés organométalliques de A. Par « composé organométallique de A », on entend, plus particulièrement, un composé de A tri-substitué, un carboxylate de A ou un phosphonate de A.

Par « composé de A tri-substitué », on entend dans le cadre de la présente invention un composé de formule (R₁)₃A dans laquelle chaque R₁, identique ou différent, représente un groupe hydrocarboné de 1 à 20 atomes de carbone tel qu'un radical alkyle, un radical alcényle, un radical alcoxy, un radical aryle ou un radical aryloxy.

Par « carboxylate de A », on entend dans le cadre de la présente invention un composé de formule (R₂CO) ₃A dans laquelle chaque R₂, identique ou différent, représente un groupe hydrocarboné de 1 à 20 atomes de carbone tel qu'un radical alkyle, un radical alcényle, un radical alcoxy, un radical aryle ou un radical aryloxy.

Par « phosphonate de A », on entend dans le cadre de la présente invention un composé de formule [R₃-P(OR₄)(OR₅)O]₃A dans laquelle
- chaque R₃, identique ou différent, représente un groupe hydrocarboné de 1 à 20 atomes de carbone tel qu'un radical alkyle, un radical alcényle, un radical alcoxy, un radical aryle ou un radical aryloxy ;
- chaque R₄, identique ou différent, représente un atome d'hydrogène ou un groupe hydrocarboné de 1 à 20 atomes de carbone tel qu'un radical alkyle, un radical alcényle, un radical alcoxy, un radical aryle ou un radical aryloxy et
- chaque R₅, identique ou différent, représente un atome d'hydrogène ou un groupe hydrocarboné de 1 à 20 atomes de carbone tel qu'un radical alkyle, un radical alcényle, un radical alcoxy, un radical aryle ou un radical aryloxy.

Dans le cadre de la présente invention et sauf mention contraire, on entend par « groupe alkyle » un groupe alkyle linéaire, ramifié ou cyclique, éventuellement substitué, de 1 à 20 atomes de carbone, notamment de 1 à 15 atomes de carbone et, en particulier, de 1 à 10 atomes de carbone.

Dans le cadre de la présente invention, on entend par « groupe alcényle » un groupe alcényle linéaire, ramifié ou cyclique, éventuellement substitué, de 2 à 20 atomes de carbone; notamment de 2 à 15 atomes de carbone et, en particulier, de 2 à 10 atomes de carbone.

Dans le cadre de la présente invention, on entend par « groupe alcoxy » un atome d'oxygène substitué par un alkyle tel que précédemment défini.

Dans le cadre de la présente invention, on entend par « groupe aryle » un groupe aromatique mono-ou polycyclique, éventuellement substitué, ayant de 6 à 20 atomes de carbone, notamment de 6 à 14 atomes de carbone, en particulier, de 6 à 8 atomes de carbone.

Dans le cadre de la présente invention, on entend par « groupe aryloxy » un atome d'oxygène substitué par un aryle tel que précédemment défini.

Dans le cadre de la présente invention, on entend par « éventuellement substitué » un radical substitué par un ou plusieurs groupes choisis parmi : un groupe alkyle, un groupe alcoxy, un halogène, un hydroxy, un cyano, un trifluorométhyle ou un nitro.

Dans le cadre de la présente invention, on entend par « halogène » un fluor, chlore, brome ou iode.

A titre d'exemples de précurseur de A utilisables dans le cadre de la présente invention, lorsque A est l'indium, on peut citer le trichlorure d'indium, le triéthyl-indium, le triacétate d'indium, le tri(acétyl-acétonate) d'indium, le trioctanoate d'indium, le tristéarate d'indium, la trilaurate d'indium, le tripalmitate d'indium, la trimyristate d'indium, le trioléate d'indium et leurs mélanges.

Dans le cadre de la présente invention, le précurseur de B mis en oeuvre est choisi dans le groupe constitué par un précurseur d'antimoine, un précurseur d'arsenic, un précurseur de phosphore, un précurseur d'azote et leurs mélanges. Tous les précurseurs d'antimoine, d'arsenic, de phosphore et d'azote connus de l'homme du métier et notamment les précurseurs se présentant sous forme liquide ou solide sont utilisables dans la présente invention.

Avantageusement, le précurseur de B mis en oeuvre dans la présente invention est un composé de formule B(F(R₆)₃)₃ ou de formule B(R₇)₃ dans lesquelles
- chaque F est choisi dans le groupe constitué par la silice (Si), le germanium (Ge) et l'étain (Sn) ;
- chaque R₆, identique ou différent, est un groupe alkyle linéaire, ramifié ou cyclique, éventuellement substitué, de 1 à 10 atomes de carbone, notamment de 1 à 6 atomes de carbone et, en particulier, de 1 à 3 atomes de carbone et
- chaque R₇, identique ou différent, est un atome d'hydrogène, un halogène tel que le chlore (Cl), brome (Br), iode (I) ou fluor (F) ou un groupe alkyle linéaire, ramifié ou cyclique, éventuellement substitué, de 1 à 10 atomes de carbone, notamment de 1 à 6 atomes de carbone et, en particulier, de 1 à 3 atomes de carbone.

En particulier, un précurseur de B et notamment un précurseur de phosphore préféré est le composé tris(triméthylsilyl) de B de formule B(Si(CH₃)₃)₃ ou B(TMS)₃.

Dans le cadre de la présente invention, le précurseur de zinc mis en oeuvre est choisi dans le groupe constitué par les sels de zinc, les halogénures de zinc, les oxydes de zinc et les composés organométalliques de zinc. Par « composé organométallique de zinc », on entend, plus particulièrement, un composé de zinc bi-substitué, un carboxylate de zinc ou un phosphonate de zinc.

Par « composé de zinc bi-substitué », on entend dans le cadre de la présente invention un composé de formule (R₈)₂Zn dans laquelle chaque R₈, identique ou différent, représente un groupe hydrocarboné de 1 à 20 atomes de carbone tel qu'un radical alkyle, un radical alcényle, un radical alcoxy, un radical aryle ou un radical aryloxy.

Par « carboxylate de zinc », on entend dans le cadre de la présente invention un composé de formule (R₉COO)₂Zn dans laquelle chaque R₉, identique ou différent, représente un groupe hydrocarboné de 1 à 20 atomes de carbone tel qu'un radical alkyle, un radical alcényle, un radical alcoxy, un radical aryle ou un radical aryloxy.

Par « phosphonate de zinc », on entend dans le cadre de la présente invention un composé de formule [R₁₀-P(OR₁₁) (OR₁₂)O]₂Zn dans laquelle
- chaque R₁₀, identique ou différent, représente un groupe hydrocarboné de 1 à 20 atomes de carbone tel qu'un radical alkyle, un radical alcényle, un radical alcoxy, un radical aryle ou un radical aryloxy ;
- chaque R₁₁, identique ou différent, représente un atome d'hydrogène, un groupe hydrocarboné de 1 à 20 atomes de carbone tel qu'un radical alkyle, un radical alcényle, un radical alcoxy, un radical aryle ou un radical aryloxy et
- chaque R₁₂, identique ou différent, représente un atome d'hydrogène, un groupe hydrocarboné de 1 à 20 atomes de carbone tel qu'un radical alkyle, un radical alcényle, un radical alcoxy, un radical aryle ou un radical aryloxy.

Les radicaux alkyle, alcényle, alcoxy, aryle et aryloxy sont tels que définis pour les précurseurs de A.

Dans le cadre de la présente invention, le précurseur de soufre mis en oeuvre est choisi dans le groupe constitué par un thiol aliphatique, le soufre élémentaire dissous dans un solvant organique et un composé de formule S(Si(R₁₃)₃)₂ dans laquelle chaque R₁₃, identique ou différent, est un groupe alkyle linéaire, ramifié ou cyclique, éventuellement substitué, de 1 à 10 atomes de carbone, notamment de 1 à 6 atomes de carbone et, en particulier, de 1 à 3 atomes de carbone.

Avantageusement, le thiol aliphatique est de formule CₙH₂ₙ₊₁-SH avec n représentant un nombre entier compris entre 1 et 25, notamment entre 5 et 20 et, en particulier, entre 8 et 18. A titre de thiols aliphatiques utilisables dans le cadre de la présente invention, on peut citer l'octanethiol (n = 8), l'octadécanethiol (n = 18), le dodécanethiol (n = 12) et leurs mélanges.

Avantageusement, le solvant organique dans lequel le soufre élémentaire est dissous est choisi parmi les trialkylphosphines dans lesquelles le groupe alkyle comprend de 4 à 12 atomes de carbone et les alcènes. A titre d'exemples de solvants organiques utilisables, on peut citer le 1-octadécène, la tributylphosphine et la trioctylphosphine.

Dans le cadre de la présente invention, le précurseur de E éventuellement mis en oeuvre est choisi dans le groupe constitué par un précurseur d'oxygène, un précurseur de sélénium, un précurseur de tellure et leurs mélanges.

Avantageusement, le précurseur de E est choisi parmi le sélénium élémentaire dissous dans un solvant organique ; le tellure élémentaire dissous dans un solvant organique ; l'acétate de zinc ; une phosphine séléniure ; un phosphine oxyde ; un composé de formule E'(Si(R₁₄)₃)₂ dans laquelle E' représente Se ou Te et chaque R₁₄, identique ou différent, est un groupe alkyle linéaire, ramifié ou cyclique, éventuellement substitué, de 1 à 10 atomes de carbone, notamment de 1 à 6 atomes de carbone et, en particulier, de 1 à 3 atomes de carbone, et leurs mélanges.

Avantageusement, le solvant organique dans lequel le sélénium élémentaire et/ou le tellure élémentaire sont dissous est choisi parmi les trialkylphosphines dans lesquelles le groupe alkyle comprend de 4 à 12 atomes de carbone et les alcènes. A titre d'exemples de solvants organiques utilisables, on peut citer le 1-octadécène, la tributylphosphine et la trioctylphosphine.

Plus particulièrement, les phosphines séléniure et oxyde susceptibles d'être utilisés dans le cadre de la présente invention sont respectivement choisis parmi les trialkylphosphines séléniure et les trialkylphosphines oxyde dans lesquelles le groupe alkyle comprend de 4 à 12 atomes de carbone.

Le mélange d'au moins un précurseur de A, d'au moins un précurseur de B, d'au moins un précurseur de zinc, d'au moins un précurseur de soufre et éventuellement d'au moins un précurseur de E, notamment le mélange préparé à l'étape (a) du procédé de l'invention, est effectué dans un solvant organique.

Avantageusement, ledit solvant organique est un alcane, une amine secondaire ou tertiaire, ou un alcène ayant un point d'ébullition supérieur à T₂ i.e. supérieur à la température choisie pour l'étape (b) du procédé selon l'invention.

Par « alcane », on entend, dans le cadre de la présente invention, un alcane linéaire, ramifié ou cyclique, éventuellement substitué, de 1 à 40 atomes de carbone, notamment de 10 à 25 atomes de carbone et, en particulier, de 14 à 20 atomes de carbone.

Par « amine secondaire ou tertiaire », on entend, dans le cadre de la présente invention, notamment les dialkylamines et trialkylamines dont le groupe alkyle comprend de 4 à 24 atomes de carbone, notamment de 8 à 20 atomes de carbone. A titre d'exemple, l'amine secondaire (tertiaire) susceptible d'être utilisée dans le cadre de la présente invention est la dioctylamine (trioctylamine) qui comporte 8 atomes de carbone par chaîne alkyle.

Par « alcène », on entend, dans le cadre de la présente invention, un alcène linéaire, ramifié ou cyclique, éventuellement substitué, de 2 à 40 atomes de carbone, notamment de 10 à 25 atomes de carbone et, en particulier, de 14 à 20 atomes de carbone.

Un solvant plus particulièrement utilisé pour préparer le mélange de précurseurs dans le procédé selon l'invention est le 1-octadécène.

De plus, le mélange de précurseurs dans ledit solvant peut contenir en outre une amine primaire. Avantageusement, l'amine primaire est une alkylamine dont le groupe alkyle comprend de 4 à 24 atomes de carbone, notamment de 8 à 20 atomes de carbone. A titre d'exemple, l'amine primaire susceptible d'être utilisée dans le cadre de la présente invention est l'héxadécylamine (HDA qui est une alkylamine à 16 atomes de carbone).

La concentration du précurseur de A et celle du précurseur de B dans le mélange lors de l'étape (a) du procédé est comprise entre 2,5 et 150 mmol/L, notamment entre 5 et 100 mmol/L et en particulier entre 10 et 20 mmol/L.

La concentration du précurseur de zinc et celle du précurseur de soufre éventuellement avec le précurseur de E est comprise entre 5 et 300 mmol/L, notamment entre 10 et 200 mmol/L et en particulier entre 20 et 40 mmol/L.

Lorsque la coquille du nanocristal est multicouche, les précurseurs des différents éléments, métaux et métalloïdes constituant les couches autres que la couche externe de la coquille sont présents, dans le mélange réactionnel, à une concentration comprise entre 5 et 300 mmol/L, notamment entre 10 et 200 mmol/L et en particulier entre 20 et 40 mmol/L.

La présente invention est basée sur l'étape essentielle de chauffage progressif du mélange réactionnel comprenant au moins un précurseur de A, au moins un précurseur de B, au moins un précurseur de zinc, au moins un précurseur de soufre et éventuellement au moins un précurseur de E. Au cours de cette étape, le chauffage progressif du mélange de la température initiale du mélange i.e. la température T₁ à une température élevée T₂ permet d'obtenir successivement la formation du coeur du nanocristal suivie de la formation de la coquille. Dans le cas d'une coquille multicouche, la formation de la coquille consiste en la formation successive des couches consécutives de la coquille.

Avantageusement, la température T₁ du mélange de précurseurs est inférieure à 50°C, notamment inférieure à 40°C et, en particulier, inférieure à 30°C. Plus particulièrement, le mélange de précurseurs est à température ambiante. Par « température ambiante », on entend une température de 20°C ± 5°C.

La température T₂ est supérieure à 180°C, notamment supérieure à 210°C, en particulier comprise entre 210°C et 320°C, et, plus particulièrement, comprise entre 230°C et 300°C. Avantageusement, la température T₂ est de l'ordre de 270°C. Par « de l'ordre de 270°C », on entend à une température de 270°C ± 20°C et notamment une température de 270°C ± 10°C.

Dans une première forme de mise en oeuvre de l'étape de chauffage et notamment l'étape (b) du procédé selon l'invention, le passage de la température T₁ à la température T₂ se fait de façon croissante linéaire.

Avantageusement, l'augmentation linéaire de la température est effectuée avec une rampe de 1 à 20°C par seconde, notamment une rampe de 2,5 à 15°C par seconde et, plus particulièrement, une rampe de 5 à 10°C par seconde.

Dans une seconde forme de mise en oeuvre de l'étape de chauffage et notamment l'étape (b) du procédé selon l'invention, le passage de la température T₁ à la température T₂ se fait de façon croissante avec au moins un palier.

Par « palier », on entend une température T comprise entre T₁ et T₂ qui est maintenue constante pendant un temps compris entre 5 secondes et 2 heures, notamment entre 15 secondes et 1 heure, en particulier entre 30 secondes et 30 minutes et, plus particulièrement, entre 1 minute et 15 minutes. L'augmentation de la température entre les températures T₁ et T₂ peut présenter de 1 à 10 paliers et notamment de 2 à 5 paliers. Entre T₁ et le premier palier, entre deux paliers consécutifs et entre le dernier palier et T₂, la température est augmentée de façon linéaire dans les conditions telles que définies pour la première forme de mise en oeuvre de l'étape de chauffage.

Lors de l'étape de chauffage du procédé de l'invention (i.e. étape (b)), une fois la température T₂ atteinte, cette température peut être maintenue constante pendant une durée comprise entre 5 minutes et 5 heures, notamment entre 15 minutes et 3,5 heures et, en particulier, entre 30 minutes et 2 heures.

L'homme du métier connait différentes techniques et différents moyens permettant de porter progressivement le mélange de précurseurs de la température T₁ à la température T₂. A titre d'exemples, on peut citer l'utilisation d'un ballon ou réacteur contenant le mélange de précurseurs, thermostaté programmable ou l'utilisation d'un bain chauffé au préalable à la température requise qui peut être la température d'un palier ou la température T₂ dans lequel est plongé le ballon ou le réacteur contenant le mélange de précurseurs.

Tous les précurseurs mis en oeuvre dans le cadre de la présente invention sont soit des produits accessibles dans le commerce, soit des produits pour lesquels l'homme du métier connaît au moins un procédé de préparation.

Dans une première variante de l'étape (a) du procédé selon l'invention, les différents précurseurs mis en oeuvre à savoir le précurseur de A, le précurseur de B, le précurseur de zinc, le précurseur de soufre et, éventuellement, le précurseur de E sont mélangés ensemble après avoir été, éventuellement, préparés au préalable. Avantageusement, lorsqu'au moins un des précurseurs mis en oeuvre à l'étape (a) du procédé est préparé au préalable, il est préparé dans un solvant aprotique identique ou différent et, avantageusement, identique au solvant mis en oeuvre lors de l'étape (a).

Lors de la préparation du mélange, les différents précurseurs peuvent être ajoutés au solvant tel que précédemment défini en même temps, les uns après les autres et/ou par groupe d'au moins deux précurseurs. En fonction des précurseurs mis en oeuvre, l'homme du métier saura déterminer la meilleure façon d'introduire les précurseurs dans le mélange.

L'exemple ci-après est un exemple de la première variante de l'étape (a) du procédé selon l'invention. Dans cet exemple, le précurseur de A est le trimyristate d'indium préparé au préalable (étape (i)), le précurseur de B est le tris(triméthylsilyl)phosphine (P(TMS)₃), le précurseur de zinc est le distéarate de zinc et le précurseur de soufre est le dodécanethiol (DDT).

Dans cet exemple, l'étape (a) du procédé correspond aux étapes (ii) et (iii) avec une étape préalable (i), lesdites étapes consistant à :
i) préparer le trimyristate d'indium par réaction d'acétate d'indium avec trois équivalents de l'acide myristique (CH₃- (CH₂)₁₂-COOH) dans de l'octadécène en chauffant à environ 100°C sous vide primaire pendant une heure. Le mélange est ensuite refroidi à température ambiante et stocké sous atmosphère inerte (azote ou argon) ;
ii) placer la quantité requise du précurseur d'indium préparé à l'étape (i) dans un ballon ou réacteur sous flux d'argon ou d'azote et agitation et, éventuellement, le diluer avec de l'octadécène ;
iii) ajouter dans ce mélange, à température ambiante, le P(TMS)₃, le distéarate de zinc et le dodécanethiol.

Après l'étape (iii), le mélange réactionnel ainsi obtenu est soumis aux étapes (b) et (c) du procédé de l'invention.

Dans une seconde variante de l'étape (a) du procédé selon l'invention, au moins un des différents précurseurs mis en oeuvre, à savoir au moins un précurseur choisi parmi le précurseur de A, le précurseur de B, le précurseur de zinc, le précurseur de soufre et, éventuellement, le précurseur de E, est préparé *in situ* lors de l'étape (a).

Dans cette variante, chacun des précurseurs non préparés *in situ* peut être ajouté, au solvant dans lequel le (ou les) précurseur(s) est (sont) préparé(s), avant, pendant et/ou après cette préparation et ce indifféremment les uns des autres. L'ajout des précurseurs peut se faire les uns après les autres et/ou par groupe d'au moins deux précurseurs. En fonction des précurseurs utilisés et des conditions mises en oeuvre pour préparer *in situ* un (ou des) précurseur(s), l'homme du métier saura déterminer la meilleure façon d'introduire les précurseurs non préparés *in situ* dans le mélange.

L'exemple ci-après est un exemple de la seconde variante de l'étape (a) du procédé selon l'invention. Dans cet exemple, le précurseur de A est le trimyristate d'indium préparé *in situ* à partir de triacétate d'indium et d'acide myristique, le précurseur de B est le P(TMS)₃, le précurseur de zinc est le distéarate de zinc et le précurseur de soufre est le DDT. L'étape (a) comprend les étapes successives (i'), (ii') et (iii') consistant à :
i') mélanger le triacétate d'indium, l'acide myristique et le P(TMS)₃ dans un ballon ;
ii') chauffer le mélange de l'étape (i') à une température comprise entre 50 et 150°C (notamment à 110°C) pendant une période de 30 min à 3 heures (notamment pendant 1 heure) sous vide primaire (notamment un vide de l'ordre de 10⁻² mBar) pour former le précurseur d'indium ;
iii') purger le mélange de l'étape (ii') avec du gaz inerte (argon ou azote) et ajouter le P(TMS)₃ et le DDT.

Après l'étape (iii'), le mélange réactionnel ainsi obtenu est soumis aux étapes (b) et (c) du procédé de l'invention.

Il convient de remarquer que, dans cet exemple particulier, les précurseurs de phosphore et de soufre sont ajoutés après la préparation du précurseur d'indium pour éviter qu'ils ne s'évaporent en partie à 100°C sous vide.

Avantageusement, les étapes (a) et (b) du procédé de l'invention sont effectuées sous agitation. Différents moyens connus de l'homme du métier peuvent être utilisés pour agiter le mélange mis en oeuvre lors des étapes (a) et (b) du procédé de l'invention. A titre d'exemples, le mélange peut être agité en utilisant un agitateur, un barreau magnétique, un bain à ultrasons ou un homogénéisateur.

Lors de l'étape (c) du procédé selon l'invention, les nanocristaux obtenus sont purifiés à partir du mélange réactionnel. L'homme du métier connait différentes techniques pour cette purification mettant en oeuvre une étape de précipitation, une étape de dilution et/ou une étape de filtration. Les techniques mises en oeuvre dans l'art antérieur pour purifier des nanocristaux luminescents sont utilisables dans le cadre de l'étape (c) du procédé de l'invention.

Avantageusement, l'étape (c) du procédé est mise en oeuvre à une température inférieure à la température T₂. Ainsi, le mélange réactionnel obtenu suite à l'étape (b) du procédé est refroidi ou laissé à refroidir jusqu'à température ambiante. Ensuite, les nanocristaux sont purifiés par précipitation en utilisant un solvant ou un mélange de solvants appropriés.

On peut utiliser, par exemple, un mélange d'un alcool tel que du méthanol et de chloroforme (avantageusement en une proportion 1:1 vol:vol) pour diluer le mélange réactionnel obtenu suite à l'étape (b) jusqu'au double volume, et ensuite précipiter avec un excès d'acétone. Les nanocristaux sont récupérés par centrifugation et peuvent ensuite être dispersés dans des solvants organiques tels que l'hexane, le toluène ou le chloroforme. L'étape (c) de purification du procédé selon l'invention peut éventuellement être répétée une ou plusieurs fois.

La présente invention concerne tout nanocristal présentant (i) un coeur comprenant un semi-conducteur comprenant A représentant un métal ou métalloïde à l'état d'oxydation +III et B représentant un élément à l'état d'oxydation -III, revêtu par (ii) une coquille dont la partie externe comprend un semi-conducteur de formule ZnS₁₋ₓEₓ, avec E représentant un élément à l'état d'oxydation -II et x étant un nombre décimal tel que 0 ≤ x < 1, susceptible d'être obtenu par un procédé selon la présente invention.

Plus particulièrement, la présente invention concerne un nanocristal présentant un coeur comprenant un semi-conducteur comprenant de l'indium et du phosphore, revêtu par une coquille dont la partie externe comprend un semi-conducteur comprenant du zinc et du soufre, susceptible d'être obtenu par un procédé selon l'invention, possèdant un rendement quantique de fluorescence supérieur à 45% à température ambiante, notamment supérieur 50% et plus particulièrement supérieur à 55%.

L'homme du métier connait différentes techniques permettant, pour un nanocristal donné, d'obtenir son rendement quantique de fluorescence à température ambiante. A titre d'exemple, on peut citer la technique consistant à comparer l'intensité d'émission intégrée spectralement, d'une dispersion de nanocristaux selon l'invention dans de l'hexane de densité optique X à une longueur d'onde d'excitation Y avec celle d'une solution de rhodamine G6 dans de l'éthanol de même intensité optique et à la même longueur d'onde d'excitation.

Les nanocristaux présentant un coeur comprenant un semi-conducteur comprenant de l'indium et du phosphore, revêtus par une coquille dont la partie externe comprend un semi-conducteur comprenant du zinc et du soufre objet de la présente invention possèdent une largeur de raie de photoluminescence inférieure à 80 nm, avantageusement inférieure à 60 nm et en particulier inférieure à 50 nm.

La présente invention concerne l'utilisation d'un nanocristal susceptible d'être préparé selon un procédé de l'invention ou d'un nanocristal selon l'invention dans une diode électroluminescente, dans une cellule photovoltaïque et pour le marquage fluorescent de molécules chimiques ou biologiques.

D'autres caractéristiques et avantages de la présente invention apparaîtront encore à l'homme du métier à la lecture des exemples ci-dessous donnés à titre illustratif et non limitatif, et faisant référence aux figures annexées.

### BRÈVE DESCRIPTION DES DESSINS

La Figure 1 présente les spectres d'absorption UV-vis des prélèvements effectués lors de l'expérience décrite au point II ci-après.
La Figure 2 présente les spectres de photoluminescence des prélèvements effectués lors de l'expérience décrite au point II ci-après. La longueur d'onde d'excitation est de 420 nm.
La Figure 3 présente les spectres de photoluminescence des échantillons préparés selon le protocole décrit au point III ci-après. La longueur d'onde d'excitation est de 420 nm.
La Figure 4 est une représentation de l'intensité de photoluminescence en fonction du temps d'irradiation avec une lampe UV (365 nm) en présence de l'air. Les nanocristaux coeur InP sont comparés aux nanocristaux préparés avec une faible quantité de dodécanethiol (In:DDT=1:0,3) et aux nanocristaux coeur/coquille InP/ZnS synthétisés avec le protocole décrit au point I ci-après (In:DDT=1:1).
La Figure 5 présente le diffractogramme de rayons X sur poudre d'un échantillon préparé selon le procédé décrit au point II ci-après, mais en utilisant 0,06 mmol de P(TMS)₃ et une température de 240°C pendant 1 heure.

### EXPOSÉ DÉTAILLÉ DE MODES DE RÉALISATION PARTICULIERS

Toutes les manipulations de matériaux sensibles à l'air sont faites en boîte à gants ou en utilisant une rampe à vide (technique de Schlenk).

Pour les caractérisations, les spectres d'absorption UV-visible ont été mesurés sur un spectromètre Hewlett-Packard 8452A (domaine spectral en longueur d'onde : 190-820 nm, résolution 2 nm), les spectres de photoluminescence ont été acquis avec un spectromètre Hitachi F-4500. Pour ces mesures spectroscopiques, les solutions colloïdales de nanocristaux diluées dans de l'hexane ont été placées dans des cuvettes en quartz de chemin optique 1 cm. Les rendements quantiques de fluorescence à température ambiante ont été obtenus par comparaison de l'intensité d'émission - intégrée spectralement - de la dispersion de nanocristaux dans l'hexane avec celle d'une solution de rhodamine 6G dans l'éthanol, les deux solutions ayant la même densité optique (< 0,03) à la longueur d'onde d'excitation (490 nm). Les diffractogrammes RX ont été obtenus sur un appareil Philips X'Pert, utilisant une source de Co, à 50 kV et 35 mA.

Tous les produits sauf le distéarate de zinc (Riédel de Haën) ont été achetés chez Sigma-Aldrich et utilisés tels que : acétate d'indium (pureté 99,99%), acide myristique (pureté >99%), distéarate de zinc (pureté 90%), dodécanethiol (pureté 97%), 1-octadécène (pureté 90%).

### I Protocole standard

### I.A. Préparation du précurseur d'indium (myristate d'indium)

2 mmol de triacétate d'indium, 6 mmol d'acide myristique et 20 mL de 1-octadécène sont placés dans un ballon de 50 ml et mélangés à l'aide d'un agitateur magnétique sous atmosphère inerte (argon ou azote). La température est montée à 110°C et le ballon est évacué à l'aide d'une pompe à vide primaire pendant 1 heure (pression dans le ballon de l'ordre de 10⁻² mbar). On obtient une solution homogène et incolore. Le ballon est ensuite rempli de gaz inerte (argon ou azote) et refroidi à température ambiante. La solution de précurseur est conservée sous atmosphère inerte, par exemple dans une boîte à gants.

### I.B. Synthèse de nanocristaux coeur/coquille InP/ZnS

Sous atmosphère inerte, 1 mL du précurseur d'indium, préparé comme décrit au point I.A, 0,2 mmol de distéarate de zinc, 0,1 mmol de P(TMS)₃, 0,2 mmol de dodécanethiol et 6 mL de 1-octadécène sont placés dans un ballon tricol de 50 mL équipé d'un condenseur et mélangés à l'aide d'un agitateur magnétique. Le mélange est chauffé à 230-300°C avec une rampe d'environ 5°C/seconde et gardé à cette température pendant 1 à 3 heures.

Après refroidissement à température ambiante, les nanocristaux InP/ZnS sont isolés par ajout d'un équivalent en volume d'un mélange chloroforme/méthanol (1:1 vol:vol) et de 10 équivalents en volume d'acétone, puis par centrifugation. Le précipité résultant contenant les nanocristaux peut être dispersé dans des solvants organiques tels que l'hexane, le toluène ou le chloroforme.

### II. Protocole pour la synthèse sans préparation préalable de la solution du précurseur d'indium.

Dans un ballon de 50 mL équipé d'un condenseur, 0,1 mmol de triacétate d'indium, 0,3 mmol d'acide myristique, 0,1 mmol de distéarate de zinc et 8,6 mL de 1-octadécène sont placés et mélangés à l'aide d'un agitateur magnétique sous atmosphère inerte.

La température est montée à 110°C et le ballon est évacué à l'aide d'une pompe à vide primaire pendant 1 heure (pression dans le ballon de l'ordre de 10⁻² mbar). On obtient une solution homogène et incolore. Le ballon est ensuite rempli du gaz inerte (argon ou azote) et refroidi à température ambiante (facultatif). 0,1 mmol de P(TMS)₃ et 1 mmol, dilué dans 1 mL de 1-octadécène, sont ajoutés au mélange qui est chauffé à 270°C avec une rampe d'environ 5°C/seconde et gardé à cette température pendant 150 minutes.

Des prélèvements sont effectués périodiquement (0,1 mL du mélange réactionnel, dilué avec 1 mL de chloroforme) et analysés par spectroscopie d'absorption UV-vis et de photoluminescence.

Après refroidissement à température ambiante, les nanocristaux InP/ZnS sont isolés par ajout d'un équivalent en volume d'un mélange chloroforme/méthanol (1:1 vol:vol) et de 10 équivalents en volume d'acétone, suivi par centrifugation. Le précipité résultant contenant les nanocristaux peut être dispersé dans des solvants organiques tels que l'hexane, le toluène ou le chloroforme.

### III. Variants du Protocole du point II

Dans cet exemple, la synthèse des nanocristaux coeur/coquille InP/ZnS a été effectuée selon des variants du protocole II précédemment décrit.

Les protocoles suivent le procédé décrit au point II, mais en utilisant les paramètres **réactionnels** résumés dans le tableau 2 suivant :

| Pic d'émission de l'échantillon (nm) | In(ac)₃:AM:DDT:Zn(st)₂¹ | Température (°C) | Temps de réaction (heures) |
|---|---|---|---|
| 585 nm | 1 :3.5 :1 :1 | 270 | 3 |
| 546 nm | 1 :3.5 :0.3 :1 | 270 | 1,5 |
| 534 nm | 1 :3.5 :1 :1* | 270 | 1,5 |
| 508 nm | 1 :3.5 :1 :1 | 240 | 1 |
| 490 nm | 1 :1 :1 :1 | 270 | 2 |

| | | | |
|---|---|---|---|
| ¹ In(ac)₃ : triacétate d'indium ; AM : acide myristique ; DDT : dodécanethiol ; Zn(st)₂ : distéarate de zinc. * pour cette réaction, l'octadécanethiol a été utilisé au lieu du dodécanethiol (DDT). | | | |

### IV. Caractérisation des nanocristaux obtenus selon le procédé de l'invention

### IV.A. Propriétés optiques

Il existe deux moyens pour contrôler la taille des nanocristaux obtenus et par conséquent leur couleur d'émission : 1) avec le temps de réaction 2) en ajustant les paramètres réactionnels.

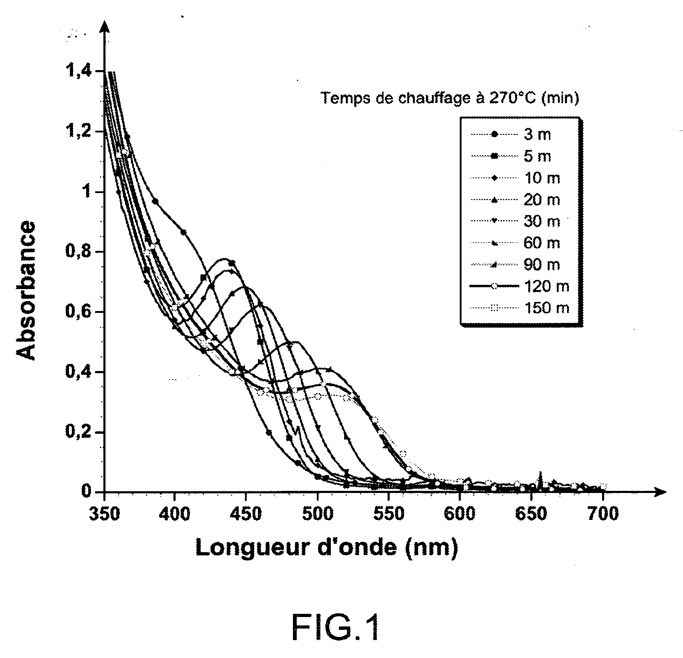

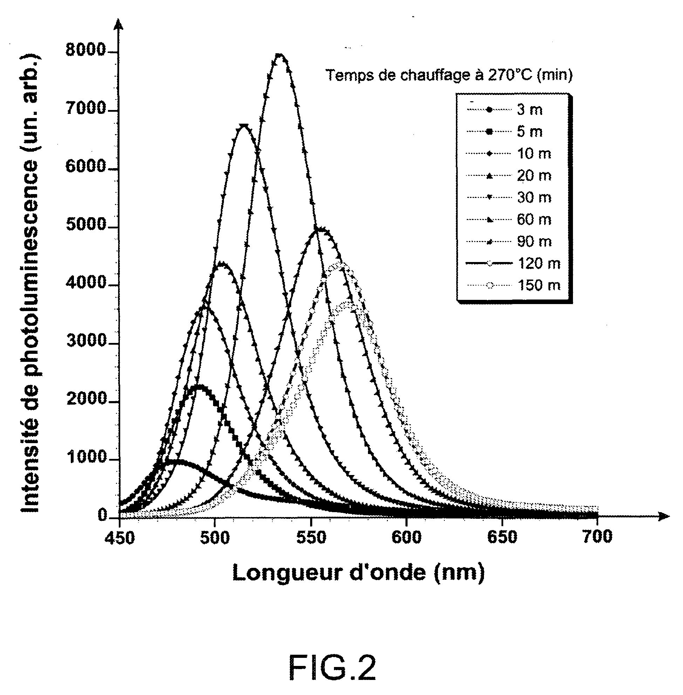

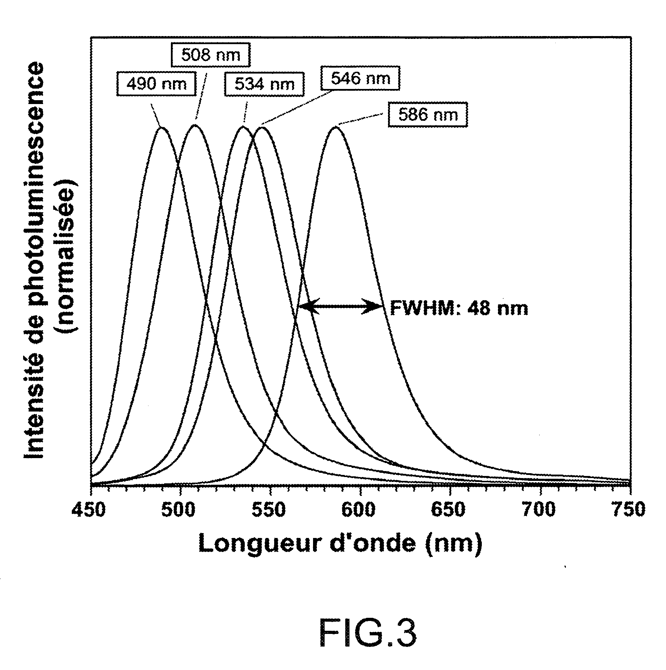

Les spectres d'absorption UV-vis et de photoluminescence des échantillons obtenus après le procédé tel que décrit au point II sont montrés aux Figures 1 et 2, respectivement. Les spectres de photoluminescence des échantillons obtenus avec le procédé tel que décrit au point III sont présentés à la Figure 3.

Le pic excitonique des échantillons est clairement prononcé, surtout pour ceux obtenus entre 5 minutes et 120 minutes de temps de réaction (Figure 1). Cette caractéristique indique une faible dispersion en taille qui se confirme en analysant les largeurs des raies dans les spectres de photoluminescence (Figure 2) qui se situent autour de 40-50 nm (FWHM, largeur de raie à mi-hauteur).

### IV.B. Stabilité des propriétés optiques

Pour l'application technologique des nanocristaux fluorescents, une attention particulière doit être accordée à la stabilité de leurs propriétés optiques dans le temps et notamment au vieillissement sous irradiation.

Afin de tester la stabilité des échantillons obtenus, on leur a fait subir une irradiation en continu avec une lampe UV émettant à 365 nm.

Cette dernière est placée à 4 cm de distance des échantillons qui se trouvent dans des cuvettes en quartz en présence de l'air. La puissance d'irradiation à cette distance est d'environ 2-3 mW.

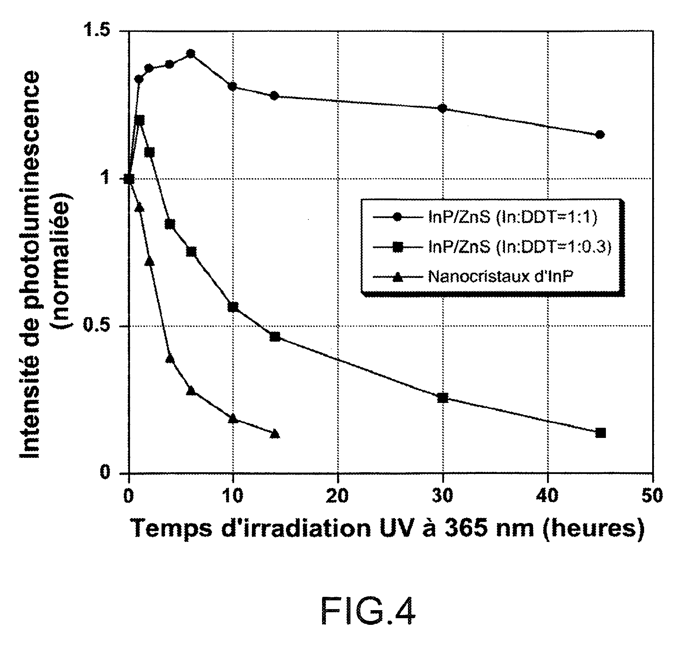

La Figure 4 montre l'évolution de l'intensité de photoluminescence de 3 échantillons différents.

On observe une diminution rapide pour les nanocristaux d'InP sans coquille de ZnS (nanocristaux ne faisant pas partie de la présente invention et utilisés à titre de comparaison) qui perdent la quasi-totalité de leur émission au bout de 10-15 heures d'irradiation.

De même, un échantillon ayant une coquille fine (In:DDT=1:0,3) préparé selon le procédé tel que décrit au point I présente une stabilité des propriétés optiques améliorées comparée à celle des nanocristaux sans coquille ZnS. Ainsi, au bout de 12 heures d'irradiation, 50% de l'intensité de photoluminescence initiale est encore détectée, et l'émission ne devient quasi-éteinte qu'après 40-50 heures.

Enfin, l'échantillon coeur/coquille fabriqué avec une quantité de précurseur de soufre supérieure (In:DDT=1:1) se comporte complètement différemment. Au début de l'irradiation (0-10 heures), on observe une augmentation de l'intensité de photoluminescence à environ 140% de sa valeur initiale. Même après 45 heures (arrêt de l'expérience) plus de 110% de l'intensité initiale est mesurée, ce qui confirme la très bonne photo-stabilité de l'échantillon.

### IV.C Analyse physico-chimique par diffractométrie de rayons X

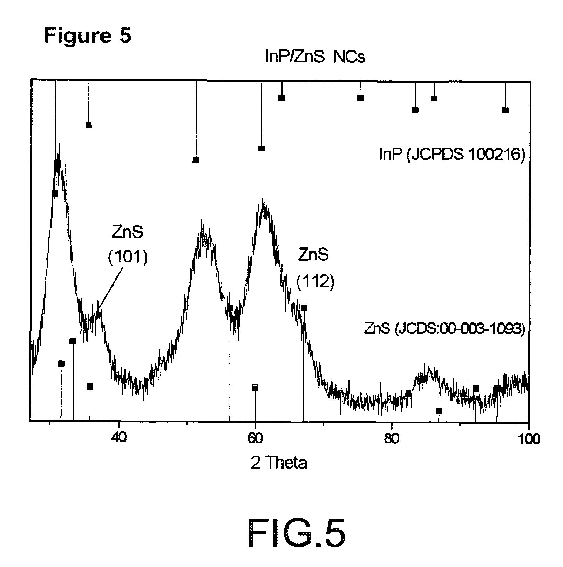

Le diffractogramme de rayons X sur poudre pour un échantillon coeur/coquille visible en Figure 5 confirme l'hétérostructure InP/ZnS. L'échantillon coeur/coquille utilisé dans cet exemple a été préparé selon le procédé tel que décrit au point II ci-après.

Les pics, élargis du fait de la taille nanométrique des cristallites, comprennent à la fois la contribution de la phase cubique d'InP (carte de « Joint Committee on Powder Diffraction Standards », JCPDS, No. 100216) et de la structure blende de zinc ZnS (carte JCPDS No. 003-1093).

### Références

1. Micic, O. I.; Curtis, C. J.; Jones, K. M.; Sprague, J. R.; Nozik, A. J., SYNTHESIS AND CHARACTERIZATION OF INP QUANTUM DOTS. Journal of Physical Chemistry 1994, 98, (19), 4966-4969.
2. Guzelian, A. A.; Katari, J. E. B.; Kadavanich, A. V.; Banin, U.; Hamad, K.; Juban, E.; Alivisatos, A. P.; Wolters, R. H.; Arnold, C. C.; Heath, J. R., Synthesis of size-selected, surface-passivated InP nanocrystals. Journal of Physical Chemistry 1996, 100, (17), 7212-7219.
3. Micic, O. I.; Sprague, J. R.; Curtis, C. J.; Jones, K. M.; Machol, J. L.; Nozik, A. J.; Giessen, H.; Fluegel, B.; Mohs, G.; Peyghambarian, N., SYNTHESIS AND CHARACTERIZATION OF INP, GAP, AND GAINP2 QUANTUM DOTS. Journal of Physical Chemistry 1995, 99, (19), 7754-7759.
4. Battaglia, D.; Peng, X. G., Formation of high quality InP and InAs nanocrystals in a noncoordinating solvent. Nano Letters 2002, 2, (9), 1027-1030.
5. Micic, O. I.; Smith, B. B.; Nozik, A. J., Core-shell quantum dots of lattice-matched ZnCdSe2 shells on InP cores: Experiment and theory. Journal of Physical Chemistry B 2000, 104, (51), 12149-12156.
6. Haubold, S.; Haase, M.; Kornowski, A.; Weller, H., Strongly luminescent InP/ZnS core-shell nanoparticles. Chemphyschem 2001, 2, (5), 331-334.
7. Xie, R.; Battaglia, D.; Peng, X., Colloidal InP nanocrystals as efficient emitters covering blue to near-infrared. Journal of the American Chemical Society 2007, 129, (50), 15432-15433.

## Revendications

1. Procédé de préparation d'un nanocristal présentant (i) un coeur comprenant un semi-conducteur comprenant A représentant un métal ou métalloïde à l'état d'oxydation +III et B représentant un élément à l'état d'oxydation -III, revêtu par (ii) une coquille dont la partie externe comprend un semi-conducteur de formule ZnS₁₋ₓEₓ, avec E représentant un élément à l'état d'oxydation -II et x étant un nombre décimal tel que 0 ≤ x < 1,
**caractérisé en ce que** ledit procédé comprend une étape consistant à porter un mélange d'au moins un précurseur de A, d'au moins un précurseur de B, d'au moins un précurseur de zinc, d'au moins un précurseur de soufre et éventuellement d'au moins un précurseur de E, d'une température T₁ à une température T₂ supérieure à T₁ de façon croissante et de manière à former, tout d'abord, ledit coeur puis ladite coquille.

2. Procédé de préparation selon la revendication 1, **caractérisé en ce que** ledit procédé comprend les étapes suivantes :
a) préparer un mélange d'au moins un précurseur de A, d'au moins un précurseur de B, d'au moins un précurseur de zinc, d'au moins un précurseur de soufre et éventuellement d'au moins un précurseur de E, à ladite température T₁,
b) porter le mélange obtenu à l'étape (a) à ladite température T₂,
c) purifier les nanocristaux présentant un coeur comprenant un semi-conducteur de formule AB entouré d'une coquille dont la couche externe comprend un semi-conducteur de formule ZnS₁₋ₓEₓ, obtenus à l'étape (b).

3. Procédé de préparation selon l'une quelconque des revendications 1 ou 2, **caractérisé en ce que** ledit nanocristal a un diamètre inférieur à 15 nm, notamment inférieur à 12 nm et en particulier inférieur à 10 nm.

4. Procédé de préparation selon l'une quelconque des revendications 1 à 3, **caractérisé en ce que** ledit précurseur de A est choisi dans le groupe constitué par un précurseur d'indium, un précurseur de gallium, un précurseur d'aluminium et leurs mélanges.

5. Procédé de préparation selon l'une quelconque des revendications précédentes, **caractérisé en ce que** ledit précurseur de A est choisi parmi les sels de A, les halogénures de A, les oxydes de A et les composés organométalliques de A.

6. Procédé de préparation selon l'une quelconque des revendications précédentes, **caractérisé en ce que** ledit précurseur de B est choisi dans le groupe constitué par un précurseur d'antimoine, un précurseur d'arsenic, un précurseur de phosphore, un précurseur d'azote et leurs mélanges.

7. Procédé de préparation selon l'une quelconque des revendications précédentes, **caractérisé en ce que** ledit précurseur de B est un composé de formule B(F(R₆)₃)₃ ou de formule B(R₇)₃ dans lesquelles :
- chaque F est choisi dans le groupe constitué par la silice (Si), le germanium (Ge) et l'étain (Sn) ;
- chaque R₆, identique ou différent, est un groupe alkyle linéaire, ramifié ou cyclique, éventuellement substitué, de 1 à 10 atomes de carbone et
- chaque R₇, identique ou différent, est un atome d'hydrogène, un halogène ou un groupe alkyle linéaire, ramifié ou cyclique, éventuellement substitué, de 1 à 10 atomes de carbone.

8. Procédé de préparation selon l'une quelconque des revendications précédentes, **caractérisé en ce que** ledit précurseur de zinc est choisi dans le groupe constitué par les sels de zinc, les halogénures de zinc, les oxydes de zinc et les composés organométalliques de zinc.

9. Procédé de préparation selon l'une quelconque des revendications précédentes, **caractérisé en ce que** ledit précurseur de soufre est choisi dans le groupe constitué par un thiol aliphatique, le soufre élémentaire dissous dans un solvant organique et un composé de formule S(Si(R₁₃)₃)₂ dans laquelle chaque R₁₃, identique ou différent, est un groupe alkyle linéaire, ramifié ou cyclique, éventuellement substitué, de 1 à 10 atomes de carbone.

10. Procédé de préparation selon l'une quelconque des revendications précédentes, **caractérisé en ce que** ledit précurseur de E est choisi dans le groupe constitué par un précurseur d'oxygène, un précurseur de sélénium, un précurseur de tellure et leurs mélanges.

11. Procédé de préparation selon l'une quelconque des revendications précédentes, **caractérisé en ce que** ledit précurseur de E est choisi parmi le sélénium élémentaire dissous dans un solvant organique ; le tellure élémentaire dissous dans un solvant organique ; l'acétate de zinc ; une phosphine séléniure ; un phosphine oxyde ; un composé de formule E'(Si(R₁₉)₃)₂ dans laquelle E' représente Se ou Te et chaque R₁₄, identique ou différent, est un groupe alkyle linéaire, ramifié ou cyclique, éventuellement substitué, de 1 à 10 atomes de carbone.

12. Procédé de préparation selon l'une quelconque des revendications précédentes, **caractérisé en ce que** ledit mélange est effectué dans un solvant organique.

13. Procédé de préparation selon la revendication 12, **caractérisé en ce que** ledit solvant organique est un alcane, une amine secondaire ou tertiaire, ou un alcène ayant un point d'ébullition supérieur à T₂.

14. Procédé de préparation selon l'une quelconque des revendications précédentes, **caractérisé en ce que** ledit mélange contient en outre une amine primaire.

15. Procédé de préparation selon l'une quelconque des revendications précédentes, **caractérisé en ce que** la température T₁ du mélange de précurseurs est inférieure à 50°C, notamment inférieure à 40°C et, en particulier, inférieure à 30°C.

16. Procédé de préparation selon l'une quelconque des revendications précédentes, **caractérisé en ce que** la température T₂ est supérieure à 180°C, notamment supérieure à 210°C, en particulier comprise entre 210°C et 320°C, et, plus particulièrement, comprise entre 230°C et 300°C.

17. Procédé de préparation selon l'une quelconque des revendications précédentes, **caractérisé en ce que** le passage de la température T₁ à la température T₂ se fait de façon croissante linéaire, avantageusement, avec une rampe de 1 à 20°C par seconde.

18. Procédé de préparation selon l'une quelconque des revendications 1 à 16, **caractérisé en ce que** le passage de la température T₁ à la température T₂ se fait de façon croissante avec au moins un palier.

19. Procédé de préparation selon l'une quelconque des revendications précédentes, **caractérisé en ce que**, une fois la température T₂ atteinte, cette température peut être maintenue constante pendant une durée comprise entre 5 minutes et 5 heures, notamment entre 15 minutes et 3,5 heures et, en particulier, entre 30 minutes et 2 heures.

20. Procédé de préparation selon l'une quelconque des revendications 2 à 19, **caractérisé en ce que** au moins un précurseur choisi parmi le précurseur de A, le précurseur de B, le précurseur de zinc, le précurseur de soufre et, éventuellement, le précurseur de E, est préparé *in situ* lors de l'étape (a).

## Claims

1. Method for preparing a nanocrystal having (i) a core comprising a semiconductor comprising A representing a metal or metalloid in the +III oxidation state and B representing an element in the -III oxidation state, coated with (ii) a shell in which the outer portion comprises a semiconductor having the formula ZnS₁₋ₓEₓ, where E represents an element in the -II oxidation state and x is a decimal number such that 0 ≤ x< 1,
**characterised in that** said method comprises a step consisting of heating a mixture of at least one precursor of A, at least one precursor of B, at least one precursor of zinc, at least one precursor of sulphur and, optionally, at least one precursor of E, from a temperature T₁ to a temperature T₂ greater than T₁ in an increasing manner and so as to form, firstly, said core then said shell.

2. Preparation method according to claim 1, **characterised in that** said method comprises the following steps:
a) preparing a mixture of at least one precursor of A, at least one precursor of B, at least one zinc precursor, at least one sulphur precursor and optionally at least one precursor of E, at said temperature T₁,
b) heating the mixture obtained in step (a) to said temperature T₂,
c) purifying the nanocrystals having a core comprising a semiconductor having the formula AB encompassed by a shell in which the outer layer comprises a semiconductor having the formula ZnS₁₋ₓEₓ, obtained in step (b).

3. Preparation method according to any of claims 1 or 2, **characterised in that** said nanocrystal has a diameter less than 15 nm, particularly less than 12 nm and in particular less than 10 nm.

4. Preparation method according to any of claims 1 to 3, **characterised in that** said precursor of A is selected from the group consisting of an indium precursor, a gallium precursor, an aluminium precursor and mixtures thereof.

5. Preparation method according to any of the preceding claims, **characterised in that** said precursor of A is selected from the salts of A, halides of A, oxides of A and organometallic compounds of A.

6. Preparation method according to any of the preceding claims, **characterised in that** said precursor of B is selected from the group consisting of an antimony precursor, an arsenic precursor, a phosphorus precursor, a nitrogen precursor and mixtures thereof.

7. Preparation method according to any of the preceding claims, **characterised in that** said precursor of B is a compound having the formula B(F(R₆)₃)₃ or the formula B(R₇)₃ wherein
- each F is selected from the group consisting of silica (Si), germanium (Ge) and tin (Sn);
- each R₆, identical or different, is a linear, branched or cyclic, optionally substituted, alkyl group, having 1 to 10 carbon atoms and
- each R₇, identical or different, is a hydrogen atom, a halogen or a linear, branched or cyclic, optionally substituted, alkyl group, having 1 to 10 carbon atoms.

8. Preparation method according to any of the preceding claims, **characterised in that** said zinc precursor is selected from the group consisting of zinc salts, zinc halides, zinc oxides and zinc organometallic compounds.

9. Preparation method according to any of the preceding claims, **characterised in that** said sulphur precursor is selected from the group consisting of an aliphatic thiol, elemental sulphur dissolved in an organic solvent and a compound having the formula S(Si(R₁₃)₃)₂ wherein each R₁₃, identical or different, is a linear, branched or cyclic, optionally substituted, alkyl group, having 1 to 10 carbon atoms.

10. Preparation method according to any of the preceding claims, **characterised in that** said precursor of E is selected from the group consisting of an oxygen precursor, a selenium precursor, a tellurium precursor and mixtures thereof.

11. Preparation method according to any of the preceding claims, **characterised in that** said precursor of E is selected from elemental selenium dissolved in an organic solvent; elemental tellurium dissolved in an organic solvent; zinc acetate; a phosphine selenide; a phosphine oxide; a compound having the formula E'(Si(R₁₄)₃)₂ wherein E' represents Se or Te and each R₁₄, identical or different, is a linear, branched or cyclic, optionally substituted, alkyl group, having 1 to 10 carbon atoms.

12. Preparation method according to any of the preceding claims, **characterised in that** said mixture is produced in an organic solvent.

13. Preparation method according to claim 12, **characterised in that** said organic solvent is an alkane, a secondary or tertiary amine, or an alkene having a boiling point greater than T₂.

14. Preparation method according to any of the preceding claims, **characterised in that** said mixture further contains a primary amine.

15. Preparation method according to any of the preceding claims, **characterised in that** the temperature T₁ of the precursor mixture is less than 50°C, particularly less than 40°C and, in particular, less than 30°C.

16. Preparation method according to any of the preceding claims, **characterised in that** the temperature T₂ is greater than 180°C, particularly greater than 210°C, in particular between 210°C and 320°C and, more specifically, between 230°C and 300°C.

17. Preparation method according to any of the preceding claims, **characterised in that** the transition from the temperature T₁ to the temperature T₂ is carried out in a linear increasing manner, advantageously, with a gradient of 1 to 20°C per second.

18. Preparation method according to any of claims 1 to 16, **characterised in that** the transition from the temperature T₁ to the temperature T₂ is carried out in an increasing manner with at least one stage.

19. Preparation method according to any of the preceding claims, **characterised in that**, once the temperature T₂ has been reached, this temperature may be kept constant for a period between 5 minutes and 5 hours, particularly between 15 minutes and 3.5 hours and, in particular, between 30 minutes and 2 hours.

20. Preparation method according to any of claims 2 to 19, **characterised in that** at least one precursor selected from the precursor of A, the precursor of B, the zinc precursor, the sulphur precursor and, optionally, the precursor of E, is prepared in situ during step (a).

## Patentansprüche

1. Verfahren zur Herstellung eines Nanokristalls, umfassend (i) einem Kern aus einem Halbleiter, bei dem A ein Metall oder Metalloid im Oxidationszustand +III repräsentiert und B ein Element im Oxidationszustand -III, umhüllt von (ii) einer Schale, deren äußerer Teil einen Halbleiter der Formel ZnS₁₋ₓEₓ umfasst, und bei dem E ein Element im Oxidationszustand -II repräsentiert und x eine Dezimalzahl ist, etwa 0 ≤ x < 1,
**dadurch gekennzeichnet, dass** das genannte Verfahren einen Schritt umfasst, der darin besteht, ein Gemisch aus wenigstens einem Vorläufer von A, wenigstens einem Vorläufer von B, wenigstens einem Vorläufer von Zink, wenigstens einem Vorläufer von Schwefel und eventuell wenigstens einem Vorläufer von E von einer Temperatur T₁ ansteigend auf eine Temperatur T₂, höher als T₁, zu bringen, um zunächst den genannten Kern, dann die genannte Schale auszubilden.

2. Herstellungsverfahren nach Anspruch 1, **dadurch gekennzeichnet, dass** das genannte Verfahren die folgenden Schritte umfasst:
a) Herstellen eines Gemisches aus wenigstens einem Vorläufer von A, wenigstens einem Vorläufer von B, wenigstens einem Zinkvorläufer, wenigstens einem Schwefelvorläufer und eventuell wenigstens einem Vorläufer von E bei der genannten Temperatur T₁,
b) Erhöhen der in Schritt (a) erreichten Temperatur auf die genannte Temperatur T₂,
c) Reinigen der in Schritt (b) erhaltenen, einen Kern aus einem Halbleiter der Formel AB umfassenden Nanokristalle, umhüllt von einer Schale, deren äußere Schicht einen Halbleiter der Formel ZnS₁₋ₓEₓ umfasst.

3. Herstellungsverfahren nach einem der Ansprüche 1 oder 2, **dadurch gekennzeichnet, dass** der genannte Nanokristall einen Durchmesser unter 15 nm, insbesondere unter 12 nm und speziell unter 10 nm hat.

4. Herstellungsverfahren nach einem der Ansprüche 1 bis 3, **dadurch gekennzeichnet, dass** der genannte Vorläufer A ausgewählt wird aus der Gruppe, die gebildet wird durch einen Indiumvorläufer, einen Galliumvorläufer, einen Aluminiumvorläufer und ihren Gemischen.

5. Herstellungsverfahren nach einem der vorhergehenden Ansprüche, **dadurch gekennzeichnet, dass** der genannte Vorläufer A ausgewählt wird unter den Salzen von A, den Halogeniden von A, den Oxiden von A und den organometallischen Verbindungen von A.

6. Herstellungsverfahren nach einem der vorhergehenden Ansprüche, **dadurch gekennzeichnet, dass** der genannte Vorläufer von B ausgewählt wird aus der Gruppe, die gebildet wird durch einen Antimonvorläufer, einen Arsenvorläufer, einen Phosphorvorläufer, einen Stickstoffvorläufer und ihren Gemischen.

7. Herstellungsverfahren nach einem der vorhergehenden Ansprüche, **dadurch gekennzeichnet, dass** der genannte Vorläufer von B eine Verbindung der Formel B(F(R₆)₃)₃ oder der Formel B(R₇)₃ ist, bei denen:
- jedes F ausgewählt wird aus der Gruppe, die gebildet wird durch Silicium (Si) bzw. Siliciumdioxid, Germanium (Ge) und Zinn (Sn);
- jedes R₆, gleich oder verschieden, eine lineare Alkylgruppe, verzweigt oder zyklisch, eventuell substituiert, von 1 bis 10 Kohlenstoffatomen ist, und
- jedes R₇, gleich oder verschieden, ein Wasserstoffatom, eine Halogen oder eine lineare Alkylgruppe, verzweigt oder zyklisch, eventuell substituiert, von 1 bis 10 Kohlenstoffatomen ist.

8. Herstellungsverfahren nach einem der vorhergehenden Ansprüche, **dadurch gekennzeichnet, dass** der genannte Zinkvorläufer ausgewählt wird aus der Gruppe, die gebildet wird durch die Zinksalze, die Zinkhalogenide, die Zinkoxide und die organometallischen Zinkverbindungen.

9. Herstellungsverfahren nach einem der vorhergehenden Ansprüche, **dadurch gekennzeichnet, dass** der genannte Schwefelvorläufer ausgewählt wird aus der Gruppe, die gebildet wird durch ein alipathisches Thiol, den in einem organischen Lösungsmittel gelösten Elementarschwefel und eine Verbindung der Formel S(Si(R₁₃)₃)₂, in der jedes R₁₃, gleich oder verschieden, eine lineare Alkylgruppe, verzweigt oder zyklisch, eventuell substituiert, von 1 bis 10 Kohlenstoffatomen ist.

10. Herstellungsverfahren nach einem der vorhergehenden Ansprüche, **dadurch gekennzeichnet, dass** der genannte Vorläufer von E ausgewählt wird aus der Gruppe, die gebildet wird durch einen Sauerstoffvorläufer, einen Selenvorläufer, einen Teilurvorläufer und ihren Gemischen.

11. Herstellungsverfahren nach einem der vorhergehenden Ansprüche, **dadurch gekennzeichnet, dass** der genannte Vorläufer von E ausgewählt wird unter Elementarselen, gelöst in einem organischen Lösungsmittel; Elementartellur, gelöst in einem organischen Lösungsmittel; Zinkacetat; einem Phosphinselenid; einem Phosphinoxid; einer Verbindung der Formel E'(Si(R₁₄)₃)₂, in der E' Se oder Te repräsentiert und jedes R₁₄, gleich oder verschieden, eine lineare Alkylgruppe, verzweigt oder zyklisch, eventuell substituiert, von 1 bis 10 Kohlenstoffatomen ist.

12. Herstellungsverfahren nach einem der vorhergehenden Ansprüche, **dadurch gekennzeichnet, dass** das genannte Gemisch in einem organischen Lösungsmittel hergestellt wird.

13. Herstellungsverfahren nach Anspruch 12, **dadurch gekennzeichnet, dass** das genannte organische Lösungsmittel ein Alkan, ein Sekundär-oder Tertiäramin oder ein Alken mit einem Siedepunkt höher als T₂ ist.

14. Herstellungsverfahren nach einem der vorhergehenden Ansprüche, **dadurch gekennzeichnet, dass** das genannte Gemisch außerdem ein Primäramin enthält.

15. Herstellungsverfahren nach einem der vorhergehenden Ansprüche, **dadurch gekennzeichnet, dass** die Temperatur T₁ des Vorläufergemisches niedriger als 50 °C, speziell niedriger als 40 °C und insbesondere niedriger als 30 °C ist.

16. Herstellungsverfahren nach einem der vorhergehenden Ansprüche, **dadurch gekennzeichnet, dass** die Temperatur T₂ höher als 180 °C, insbesondere höher als 210 °C ist, speziell enthalten zwischen 210 °C und 320 °C und noch spezieller zwischen 230 °C und 300 °C.

17. Herstellungsverfahren nach einem der vorhergehenden Ansprüche, **dadurch gekennzeichnet, dass** der Übergang von der Temperatur T₁ zur Temperatur T₂ auf linear ansteigende Weise erfolgt, vorzugsweise mit einer Rampe von bis 20 °C pro Sekunde.

18. Herstellungsverfahren nach einem der Ansprüche 1 bis 16, **dadurch gekennzeichnet, dass** der Übergang von der Temperatur T₁ zur Temperatur T₂ auf ansteigende Weise mit mindestens einer Stufe erfolgt.

19. Herstellungsverfahren nach einem der vorhergehenden Ansprüche, **dadurch gekennzeichnet, dass** die Temperatur T₂, sobald sie erreicht ist, konstant gehalten werden kann während einer zwischen 5 Minuten und 5 Stunden, insbesondere zwischen 15 Minuten und 3.5 Stunden und speziell zwischen 30 Minuten und 2 Stunden enthaltenen Dauer.

20. Herstellungsverfahren nach einem der Ansprüche 2 bis 19, **dadurch gekennzeichnet, dass** wenigstens ein Vorläufer, ausgewählt unter dem Vorläufer A, dem Vorläufer B, dem Zinkvorläufer, dem Schwefelvorläufer und eventuell dem Vorläufer E während des Schritts (a) in situ hergestellt wird.
